# EUROPEAN PATENT APPLICATION

(11) **EP 4 407 959 A1**
(43) Date of publication of application: **31.07.2024**
(21) Application number: 22897665.0
(22) Date of filing: 16.11.2022
(51) Int. Cl.: H04L 69/04, H04L 69/164, H04N 19/93, H04N 19/91, G01S 17/931, G01S 17/08

(54) **METHOD AND APPARATUS FOR COMPRESSING RADAR DATA**

(30) Priority: 23.11.2021 CN 202111393470
(71) Applicant: Huawei Technologies Co., Ltd., Shenzhen, Guangdong 518129 (CN)
(72) Inventor: TU, Chenxi, Shenzhen, Guangdong 518129 (CN); CAI, Kangying, Shenzhen, Guangdong 518129 (CN); CAO, Xiaoran, Shenzhen, Guangdong 518129 (CN)
(74) Representative: Epping - Hermann - Fischer
(86) International application number: PCT/CN2022/132107
(87) International publication number: WO 2023/093582

(57) **Abstract**

This application provides a method for compressing lidar data and an apparatus. The method for compressing lidar data includes: obtaining to-be-compressed data, where the to-be-compressed data is measurement data collected by lidar through N transmissions, and N ≥ 1; when the to-be-compressed data includes corresponding distance measurement data and signal intensity measurement data, compressing the distance measurement data to obtain a first bitstream; and predicting the signal intensity measurement data based on the distance measurement data to obtain a second bitstream. In this application, an amount of the to-be-compressed data can be greatly reduced. In particular, a larger quantity of 0 values indicates higher compression efficiency. This reduces occupied bitstreams.

## Description

This application claims priority to Chinese Patent Application 202111393470.5, filed with the China National Intellectual Property Administration on November 23, 2021, and entitled "METHOD FOR COMPRESSING LIDAR DATA AND APPARATUS", which is incorporated herein by reference in its entirety.

### TECHNICAL FIELD

This application relates to radar technologies, and in particular, to a method for compressing lidar data and an apparatus.

### BACKGROUND

Lidar for obtaining point cloud data plays an important role in each algorithm module (for example, positioning, obstacle avoidance, or the like) of autonomous driving. In recent years, as lidar technologies evolve, durability of lidar is greatly improved, a unit price decreases to be commercially acceptable, and various types of automotive-grade lidar emerge. Currently, lidar becomes a standard sensor for level-4 autonomous driving, and is used in many production models.

However, data transmission of lidar gradually becomes a major pain point. With the pursuit of high-resolution point cloud, a quantity of beams of lidar increases, and transmission of raw data of a single lidar may need a bandwidth of 100 Mbps or above. For safety and reliability reasons, autonomous vehicles are usually equipped with cameras, millimeter wave radars, and other sensors, causing greater pressure to data transmission and storage.

It can be learned that, to meet requirements of lidar for data transmission and storage, an efficient compression algorithm is indispensable.

### SUMMARY

This application provides a method for compressing lidar data and an apparatus, so that an amount of to-be-compressed data can be greatly reduced. In particular, a larger quantity of 0 values indicates higher compression efficiency. This reduces occupied bitstreams.

According to a first aspect, this application provides a method for compressing lidar data, including: obtaining a bitstream; obtaining, based on the bitstream, a first bitstream corresponding to distance measurement data; decompressing the first bitstream to obtain the distance measurement data; and obtaining signal intensity measurement data based on the distance measurement data.

As described above, raw data of lidar is a user datagram protocol (UDP) data packet or packet data. UDP data is sorted to obtain packet data. In the packet data, one data block corresponds to one lidar transmission. One block includes one piece of azimuth angle measurement data and a plurality of groups of distance measurement data and signal intensity measurement data. The distance measurement data and the signal intensity measurement data are in a one-to-one correspondence.

In an embodiment of this application, different compression methods may be applied to different types of measurement data. For the distance measurement data, a compression method applied to an encoder includes the following steps.

In a possible implementation, when to-be-compressed data includes a plurality of pieces of 0-value distance measurement data, run-length encoding is performed on the plurality of pieces of 0-value distance measurement data to obtain the first bitstream.

In a possible implementation, when to-be-compressed data includes a plurality of pieces of non-0 distance measurement data, residual-based entropy encoding is performed on the plurality of pieces of non-0 distance measurement data to obtain the first bitstream.

There is a correspondence between distance measurement data and signal intensity measurement data in a same group. Correspondingly, values of the distance measurement data and the signal intensity measurement data in the same group have an association. For example, when the distance measurement data is 0, the signal intensity measurement data corresponding to the distance measurement data is usually also 0. When the distance measurement data is 0, it indicates that the signal is too weak to provide valid information. Therefore, the distance measurement data is ignored and marked as 0. Correspondingly, the signal intensity measurement data corresponding to the distance measurement data is also marked as 0. Therefore, cross-modal compression may be performed on the distance measurement data and the signal intensity measurement data, to implement optimal compression efficiency.

In a possible implementation, when the distance measurement data is 0, the signal intensity measurement data corresponding to the distance measurement data is also 0. Therefore, the encoder may not process this type of signal intensity measurement data, so that a data amount can be greatly reduced. A larger quantity of 0 values indicates higher compression efficiency. This reduces occupied bitstreams.

In a possible implementation, in addition to the foregoing relationship in which a 0 value corresponds to a 0 value, a calculation relationship may exist between the values of the distance measurement data and the signal intensity measurement data in the same group, so that a data amount can be greatly reduced. A larger amount of signal intensity measurement data that has a calculation relationship with the distance measurement data indicates higher compression efficiency. This reduces occupied bitstreams.

In a possible implementation, when the distance measurement data is non-0, the signal intensity measurement data corresponding to the distance measurement data is predicted based on one or more pieces of non-0 distance measurement data to obtain a residual of the signal intensity measurement data. Then, a second bitstream is obtained based on the residual of the signal intensity measurement data.

In a possible implementation, when to-be-compressed data includes a plurality of pieces of non-0 distance measurement data, residual-based entropy encoding is performed on a plurality of pieces of signal intensity measurement data corresponding to the plurality of pieces of non-0 distance measurement data to obtain the second bitstream.

In a possible implementation, non-0 distance measurement data is obtained, non-0 signal intensity measurement data corresponding to the non-0 distance measurement data is predicted based on one or more pieces of non-0 distance measurement data to obtain a first residual, another piece of non-0 signal intensity measurement data is predicted based on the non-0 signal intensity measurement data to obtain a second residual, and finally the second bitstream is obtained based on the first residual and the second residual.

In an embodiment of this application, the distance measurement data and the signal intensity measurement data in the same group are compressed in a cross-modal manner based on the association between the distance measurement data and the signal intensity measurement data in the same group, so that an amount of to-be-compressed data is greatly reduced. In particular, a larger quantity of 0 values indicates higher compression efficiency. This reduces occupied bitstreams.

In a possible implementation, the method further includes: obtaining, based on the bitstream, a third bitstream corresponding to time measurement data; and decompressing the third bitstream to obtain the time measurement data. In a possible implementation, the method further includes: obtaining, based on the bitstream, a fourth bitstream corresponding to azimuth angle measurement data; and decompressing the fourth bitstream to obtain the azimuth angle measurement data.

The decompressing includes run-length decoding, entropy decoding, or residual-based entropy decoding.

According to a second aspect, this application provides a method for compressing lidar data, including: obtaining to-be-compressed data, where the to-be-compressed data is measurement data collected by lidar through N transmissions, and N ≥ 1; when the to-be-compressed data includes corresponding distance measurement data and signal intensity measurement data, compressing the distance measurement data to obtain a first bitstream; and predicting the signal intensity measurement data based on the distance measurement data to obtain a second bitstream.

The bitstream includes at least one of the following: the first bitstream, the second bitstream, a third bitstream, and a fourth bitstream. For the solution in an embodiment of this application, the distance measurement data and the signal intensity measurement data are mainly considered. Therefore, the bitstream needs to include at least the first bitstream. Optionally, the bitstream may carry some syntax elements to indicate meanings of different fields in the bitstream. Optionally, an encoder and a decoder may agree on lengths of different bitstreams in advance, and determine, based on a byte or a bit of a currently parsed bitstream, which bitstream in the foregoing four bitstreams is the currently parsed bitstream.

In a possible implementation, run-length decoding is performed on the first bitstream to obtain a plurality of consecutive pieces of 0-value distance measurement data. Corresponding to the encoder, the decoder may perform run-length decoding on a corresponding field in the bitstream according to an indication of the syntax element, to obtain the plurality of consecutive pieces of 0-value distance measurement data.

In a possible implementation, entropy decoding is performed on the first bitstream to obtain distance measurement data other than the plurality of consecutive pieces of 0-value distance measurement data.

In a possible implementation, when the distance measurement data is 0, the signal intensity measurement data corresponding to the distance measurement data is set to 0.

In a possible implementation, when the distance measurement data is non-0, the signal intensity measurement data corresponding to the distance measurement data is obtained through calculation only based on the distance measurement data; or when the distance measurement data is non-0, the signal intensity measurement data corresponding to the distance measurement data is obtained through calculation only based on one or more pieces of non-0 distance measurement data obtained through decoding.

In a possible implementation, the second bitstream corresponding to the signal intensity measurement data is obtained based on the bitstream, the second bitstream is decompressed to obtain a residual of non-0 signal intensity measurement data, and the non-0 signal intensity measurement data is obtained based on the residual and one or more pieces of non-0 distance measurement data obtained through decoding.

In a possible implementation, the second bitstream corresponding to the signal intensity measurement data is obtained based on the bitstream, and the second bitstream is decompressed to obtain non-0 signal intensity measurement data. In a possible implementation, non-0 signal intensity measurement data is obtained through prediction based on one or more pieces of non-0 distance measurement data obtained through decoding, and another piece of non-0 signal intensity measurement data is obtained through prediction based on the non-0 signal intensity measurement data.

In an embodiment of this application, distance measurement data and signal intensity measurement data in a same group are decompressed in a cross-modal manner based on an association between the distance measurement data and the signal intensity measurement data in the same group. Because bitstreams for partial signal intensity measurement data can be saved in the bitstream, a bitstream length is greatly reduced, and compression efficiency is improved.

In a possible implementation, the method further includes: when the to-be-compressed data further includes time measurement data, performing run-length encoding, entropy encoding, or residual-based entropy encoding on the time measurement data to obtain the third bitstream; and/or when the to-be-compressed data further includes azimuth angle measurement data, performing run-length encoding, entropy encoding, or residual-based entropy encoding on the azimuth angle measurement data to obtain the fourth bitstream.

According to a third aspect, this application provides a method for compressing lidar data, including: obtaining to-be-compressed data, where the to-be-compressed data is measurement data collected by lidar through N transmissions, and N ≥ 1; and when the to-be-compressed data includes a plurality of pieces of 0-value distance measurement data, performing run-length encoding on the plurality of pieces of 0-value distance measurement data to obtain a first bitstream.

In a possible implementation, the method further includes: when the to-be-compressed data includes a plurality of pieces of non-0 distance measurement data, performing residual-based entropy encoding on the plurality of pieces of non-0 distance measurement data to obtain the first bitstream.

In a possible implementation, the method further includes: when the to-be-compressed data further includes signal intensity measurement data, performing run-length encoding, entropy encoding, or residual-based entropy encoding on the signal intensity measurement data to obtain a second bitstream; when the to-be-compressed data further includes time measurement data, performing run-length encoding, entropy encoding, or residual-based entropy encoding on the time measurement data to obtain a third bitstream; and/or when the to-be-compressed data further includes azimuth angle measurement data, performing run-length encoding, entropy encoding, or residual-based entropy encoding on the azimuth angle measurement data to obtain a fourth bitstream.

According to a fourth aspect, this application provides a method for decompressing lidar data, including: obtaining a bitstream; obtaining, based on the bitstream, a first bitstream corresponding to distance measurement data; and performing run-length decoding on the first bitstream to obtain a plurality of consecutive pieces of 0-value distance measurement data.

In a possible implementation, the method further includes: performing entropy decoding on the first bitstream to obtain distance measurement data other than the plurality of consecutive pieces of 0-value distance measurement data.

In a possible implementation, the method further includes: obtaining, based on the bitstream, a second bitstream corresponding to signal intensity measurement data; and decompressing the second bitstream to obtain the signal intensity measurement data.

In a possible implementation, the method further includes: obtaining, based on the bitstream, a third bitstream corresponding to time measurement data; and decompressing the third bitstream to obtain the time measurement data. In a possible implementation, the method further includes: obtaining, based on the bitstream, a fourth bitstream corresponding to azimuth angle measurement data; and decompressing the fourth bitstream to obtain the azimuth angle measurement data.

In a possible implementation, the decompressing includes run-length decoding, entropy decoding, or residual-based entropy decoding.

According to a fifth aspect, this application provides a decompression apparatus, including: an obtaining module, configured to: obtain a bitstream; and obtain, based on the bitstream, a first bitstream corresponding to distance measurement data; and a decompression module, configured to: decompress the first bitstream to obtain the distance measurement data; and obtain signal intensity measurement data based on the distance measurement data.

In a possible implementation, the decompression module is specifically configured to: when the distance measurement data is 0, set the signal intensity measurement data corresponding to the distance measurement data to 0.

In a possible implementation, the decompression module is specifically configured to: when the distance measurement data is non-0, obtain, through calculation only based on the distance measurement data, the signal intensity measurement data corresponding to the distance measurement data; or when the distance measurement data is non-0, obtain, through calculation only based on one or more pieces of non-0 distance measurement data obtained through decoding, the signal intensity measurement data corresponding to the distance measurement data.

In a possible implementation, the decompression module is specifically configured to: obtain, based on the bitstream, a second bitstream corresponding to the signal intensity measurement data; decompress the second bitstream to obtain a residual of non-0 signal intensity measurement data; and obtain the non-0 signal intensity measurement data based on the residual and one or more pieces of non-0 distance measurement data obtained through decoding.

In a possible implementation, the obtaining module is further configured to obtain, based on the bitstream, a second bitstream corresponding to the signal intensity measurement data; and the decompression module is further configured to decompress the second bitstream to obtain non-0 signal intensity measurement data.

In a possible implementation, the decompression module is specifically configured to: obtain non-0 signal intensity measurement data through prediction based on one or more pieces of non-0 distance measurement data obtained through decoding; and obtain another piece of non-0 signal intensity measurement data through prediction based on the non-0 signal intensity measurement data.

In a possible implementation, the decompression module is specifically configured to perform run-length decoding on the first bitstream to obtain a plurality of consecutive pieces of 0-value distance measurement data.

In a possible implementation, the decompression module is specifically configured to perform entropy decoding on the first bitstream to obtain distance measurement data other than the plurality of consecutive pieces of 0-value distance measurement data.

In a possible implementation, the obtaining module is further configured to obtain, based on the bitstream, a third bitstream corresponding to time measurement data; and the decompression module is further configured to decompress the third bitstream to obtain the time measurement data.

In a possible implementation, the obtaining module is further configured to obtain, based on the bitstream, a fourth bitstream corresponding to azimuth angle measurement data; and the decompression module is further configured to decompress the fourth bitstream to obtain the azimuth angle measurement data.

In a possible implementation, the decompressing includes run-length decoding, entropy decoding, or residual-based entropy decoding.

According to a sixth aspect, this application provides a compression apparatus, including: an obtaining module, configured to obtain to-be-compressed data, where the to-be-compressed data is measurement data collected by lidar through N transmissions, and N ≥ 1; and a compression module, configured to: when the to-be-compressed data includes corresponding distance measurement data and signal intensity measurement data, compress the distance measurement data to obtain a first bitstream; and predict the signal intensity measurement data based on the distance measurement data to obtain a second bitstream.

In a possible implementation, the compression module is specifically configured to: when the distance measurement data is non-0, predict, based on one or more pieces of non-0 distance measurement data, the signal intensity measurement data corresponding to the distance measurement data to obtain a residual of the signal intensity measurement data; and obtain the second bitstream based on the residual of the signal intensity measurement data.

In a possible implementation, the compression module is specifically configured to: when the to-be-compressed data includes a plurality of pieces of non-0 distance measurement data, perform residual-based entropy encoding on a plurality of pieces of signal intensity measurement data corresponding to the plurality of pieces of non-0 distance measurement data to obtain the second bitstream.

In a possible implementation, the compression module is specifically configured to: obtain non-0 distance measurement data; predict, based on one or more pieces of non-0 distance measurement data, non-0 signal intensity measurement data corresponding to the non-0 distance measurement data to obtain a first residual; predict another piece of non-0 signal intensity measurement data based on the non-0 signal intensity measurement data to obtain a second residual; and obtain the second bitstream based on the first residual and the second residual.

In a possible implementation, the compression module is specifically configured to: when the to-be-compressed data includes a plurality of pieces of 0-value distance measurement data, perform run-length encoding on the plurality of pieces of 0-value distance measurement data to obtain the first bitstream; or when the to-be-compressed data includes a plurality of pieces of non-0 distance measurement data, perform residual-based entropy encoding on the plurality of pieces of non-0 distance measurement data to obtain the first bitstream.

In a possible implementation, the compression module is further configured to: when the to-be-compressed data further includes time measurement data, perform run-length encoding, entropy encoding, or residual-based entropy encoding on the time measurement data to obtain a third bitstream; and/or when the to-be-compressed data further includes azimuth angle measurement data, perform run-length encoding, entropy encoding, or residual-based entropy encoding on the azimuth angle measurement data to obtain a fourth bitstream.

According to a seventh aspect, this application provides a compression apparatus, including: an obtaining module, configured to obtain to-be-compressed data, where the to-be-compressed data is measurement data collected by lidar through N transmissions, and N ≥ 1; and a compression module, configured to: when the to-be-compressed data includes a plurality of pieces of 0-value distance measurement data, perform run-length encoding on the plurality of pieces of 0-value distance measurement data to obtain a first bitstream.

In a possible implementation, the compression module is further configured to: when the to-be-compressed data includes a plurality of pieces of non-0 distance measurement data, perform residual-based entropy encoding on the plurality of pieces of non-0 distance measurement data to obtain the first bitstream.

In a possible implementation, the compression module is further configured to: when the to-be-compressed data further includes signal intensity measurement data, perform run-length encoding, entropy encoding, or residual-based entropy encoding on the signal intensity measurement data to obtain a second bitstream; when the to-be-compressed data further includes time measurement data, perform run-length encoding, entropy encoding, or residual-based entropy encoding on the time measurement data to obtain a third bitstream; and/or when the to-be-compressed data further includes azimuth angle measurement data, perform run-length encoding, entropy encoding, or residual-based entropy encoding on the azimuth angle measurement data to obtain a fourth bitstream.

According to an eighth aspect, this application provides a decompression apparatus, including: an obtaining module, configured to: obtain a bitstream; and obtain, based on the bitstream, a first bitstream corresponding to distance measurement data; and a decompression module, configured to perform run-length decoding on the first bitstream to obtain a plurality of consecutive pieces of 0-value distance measurement data.

In a possible implementation, the decompression module is further configured to perform entropy decoding on the first bitstream to obtain distance measurement data other than the plurality of consecutive pieces of 0-value distance measurement data.

In a possible implementation, the obtaining module is further configured to obtain, based on the bitstream, a second bitstream corresponding to signal intensity measurement data; and the decompression module is further configured to decompress the second bitstream to obtain the signal intensity measurement data.

In a possible implementation, the obtaining module is further configured to obtain, based on the bitstream, a third bitstream corresponding to time measurement data; and the decompression module is further configured to decompress the third bitstream to obtain the time measurement data.

In a possible implementation, the obtaining module is further configured to obtain, based on the bitstream, a fourth bitstream corresponding to azimuth angle measurement data; and the decompression module is further configured to decompress the fourth bitstream to obtain the azimuth angle measurement data.

In a possible implementation, the decompressing includes run-length decoding, entropy decoding, or residual-based entropy decoding.

According to a ninth aspect, this application provides an electronic device, including: one or more processors; and a memory, configured to store one or more programs. When the one or more programs are executed by the one or more processors, the one or more processors are enabled to implement the method according to any one of the first aspect to the fourth aspect.

According to a tenth aspect, this application provides a computer-readable storage medium, including a computer program. When the computer program is executed on a computer, the computer is enabled to perform the method according to any one of the first aspect to the fourth aspect.

According to an eleventh aspect, this application provides a computer program product. The computer program product includes computer program code. When the computer program code is run on a computer, the method according to any one of the first aspect to the fourth aspect is performed.

### BRIEF DESCRIPTION OF DRAWINGS

FIG. 1 is an example block diagram of a coding system 10 according to an embodiment of this application;
FIG. 2 is a flowchart of a process 200 of a method for compressing lidar data according to an embodiment of this application;
FIG. 3a is a schematic of a format of UDP data according to an embodiment of this application;
FIG. 3b is a schematic of a format of packet data according to an embodiment of this application;
FIG. 3c is a schematic of a two-dimensional matrix according to an embodiment of this application;
FIG. 4 is a flowchart of a process 400 of a method for decompressing lidar data according to an embodiment of this application;
FIG. 5 is a schematic flowchart of a method for compressing/decompressing lidar data according to an embodiment of this application;
FIG. 6 is an example schematic of a structure of a compression apparatus 600 according to an embodiment of this application; and
FIG. 7 is an example schematic of a structure of a decompression apparatus 700 according to an embodiment of this application.

### DESCRIPTION OF EMBODIMENTS

To make objectives, technical solutions, and advantages of this application clearer, the following clearly and completely describes the technical solutions in this application with reference to the accompanying drawings in this application. It is clear that the described embodiments are merely some rather than all of embodiments of this application. All other embodiments obtained by a person of ordinary skill in the art based on embodiments of this application without creative efforts shall fall within the protection scope of this application.

In the specification, embodiments, claims, and accompanying drawings of this application, the terms "first", "second", and the like are merely intended for distinguishing and description, and shall not be understood as indicating or implying relative importance, or indicating or implying a sequence. In addition, the terms "include", "have", and any variant thereof are intended to cover non-exclusive inclusion. For example, a process, method, system, product, or device that includes a series of steps or units is not necessarily limited to those steps or units expressly listed, but may include other steps or units not expressly listed or inherent to such a process, method, system, product, or device.

It should be understood that in this application, "at least one (item)" refers to one or more and "a plurality of" refers to two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" usually indicates an "or" relationship between associated objects. The expression "at least one of the following items (pieces)" or a similar expression means any combination of these items, including a single item (piece) or any combination of a plurality of items (pieces). For example, at least one of a, b, or c may indicate a, b, c, a and b, a and c, b and c, or a, b, and c, where a, b, and c may be singular or plural.

The following are related terms in embodiments of this application.

Raw data: Raw data of lidar is a user datagram protocol (UDP) data packet or packet data.

UDP data: Data is transmitted over a network based on a UDP protocol. Direct output data of lidar is transmitted in a form of UDP data. The UDP data is parsed and sorted to obtain packet data.

Packet data: Packet data is a storage form of raw data of lidar, and a UDP data packet may be sorted to obtain the packet data. The packet data includes information such as distance, signal intensity, azimuth angle, laser identity (ID), and timestamp of each point. The packet data generally includes information of multiple transmissions. The packet data may be directly input to a calibration algorithm, and point cloud is obtained after calibration. The foregoing calibration process is irreversible.

Point cloud: Point cloud is a data set of points in a coordinate system. The point cloud includes rich information, for example, three-dimensional coordinates (X, Y, Z), color, classification value, intensity value, and the like of a point. A dense point cloud may be used to restore a three-dimensional real world. Point cloud of lidar is usually obtained by calibrating packet data.

One transmission: A process in which lidar emits all lasers and receives reflections is referred to as one transmission. A quantity of points that can be obtained in one transmission is related to a quantity of beams of the lidar. For example, 32-beam lidar can theoretically emit 32 lasers and receive 32 reflections in one transmission, and a total of 32 points are obtained.

A method for compressing data of lidar substantially includes two types: compressing point cloud, and compressing raw data of lidar, for example, UDP data packet or packet data.

In many algorithms for compressing raw data of lidar, packet data is arranged into a 2D matrix according to a working principle and a data format of the lidar, and then compressed by using an image compression method. However, matrixed packet data is distributed quite differently from pixel data of an image. Therefore, many algorithms in an image coding technology are not applicable to the matrixed packet data.

Based on this, an embodiment of this application provides a method for compressing lidar data, to implement efficient compression of lidar data.

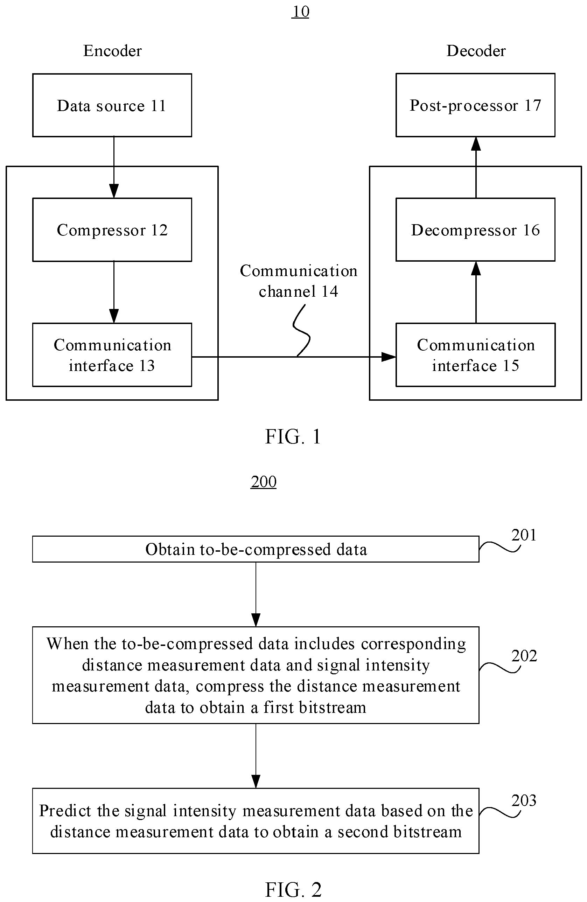

FIG. 1 is an example block diagram of an coding system 10 according to an embodiment of this application. A compressor 12 and a decompressor 16 in the coding system 10 represent devices and the like that may be used to perform various techniques according to various examples described in embodiments of this application.

As shown in FIG. 1, the coding system 10 includes an encoder and a decoder. The encoder is configured to compress lidar data, and provide a compressed bitstream for the decoder. The decoder decompresses the bitstream to obtain reconstructed lidar data.

The encoder includes the compressor 12, and may optionally include a data source 11 and a communication interface 13.

The data source 11 may include or may be any type of lidar for obtaining measurement data. Alternatively, the data source 11 may include or may be any type of memory or storage. Data output by the data source 11 is raw data of lidar. The raw data may be UDP data, or may be packet data.

The compressor 12 is configured to receive raw data, and compress the raw data to obtain a bitstream.

The communication interface 13 may be configured to receive a bitstream, and send the bitstream to the decoder on a communication channel 14.

The decoder includes a decompressor 16, and may optionally include a communication interface 15 and a post-processor 17.

The communication interface 15 is configured to directly receive a bitstream from the encoder or from any other device such as a storage device, and provide the bitstream to the decompressor 16.

The communication interface 13 and the communication interface 15 may be configured to send or receive a bitstream over a direct communication link between the encoder and the decoder, for example, a direct wired connection or a wireless connection, or by using any type of network, for example, a wired network, a wireless network, or any combination thereof, or any type of private network and public network or any type of combination thereof.

The communication interface 13 and the communication interface 15 may be configured as unidirectional communication interfaces or bidirectional communication interfaces indicated by an arrow that corresponds to the communication channel 14 and that points from the encoder to the decoder in FIG. 1, and may be configured to send and receive a message and the like, establish a connection, and determine and exchange any other information related to a communication link and/or data transmission such as encoded picture data transmission.

The post-processor 17 is configured to post-process decoded data (also referred to as reconstructed lidar data) to obtain post-processed lidar data. Post-processing performed by the post-processor 17 may include, for example, conversion of UDP data/packet data into point cloud.

Although FIG. 1 shows that the encoder and the decoder are used as independent devices, the device embodiment may also include both an encoding device and a decoding device or both encoding and decoding functions, that is, include both the encoder or a corresponding function and the decoder or a corresponding function. In these embodiments, the encoder or the corresponding function and the decoder or the corresponding function may be implemented by using same hardware and/or software or by using separate hardware and/or software or any combination thereof.

According to the description, it is clear for a person skilled in the art that the existence and (accurate) division of different units or functions in the encoder and/or the decoder shown in FIG. 1 may vary depending on actual devices and applications.

The encoder and the decoder may include any one of various devices, including any type of handheld device or fixed device, for example, a notebook computer or laptop computer, a smartphone, a tablet or tablet computer, a desktop computer, and the like, and may not use or use any type of operating system. In some cases, the encoder and the decoder may be equipped with components for wireless communication. Therefore, the encoder and the decoder may be wireless communication devices.

It should be noted that the coding system 10 shown in FIG. 1 is merely an example. In some cases, the encoder and the decoder may be used in a same device or different devices. The coding system for lidar data is not specifically limited in embodiments of this application.

Based on this, FIG. 2 is a flowchart of a process 200 of a method for compressing lidar data according to an embodiment of this application. The process 200 may be performed by the encoder (particularly the compressor 12) in the coding system 10. The process 200 is described as a series of steps or operations. It should be understood that the process 200 may be performed in various sequences and/or may occur simultaneously, and is not limited to an execution sequence shown in FIG. 2. It is assumed that the coding system 10 is used to compress measurement data collected by lidar through N transmissions in the process 200 including the following steps. The process 200 may include the following steps.

Step 201: Obtain to-be-compressed data.

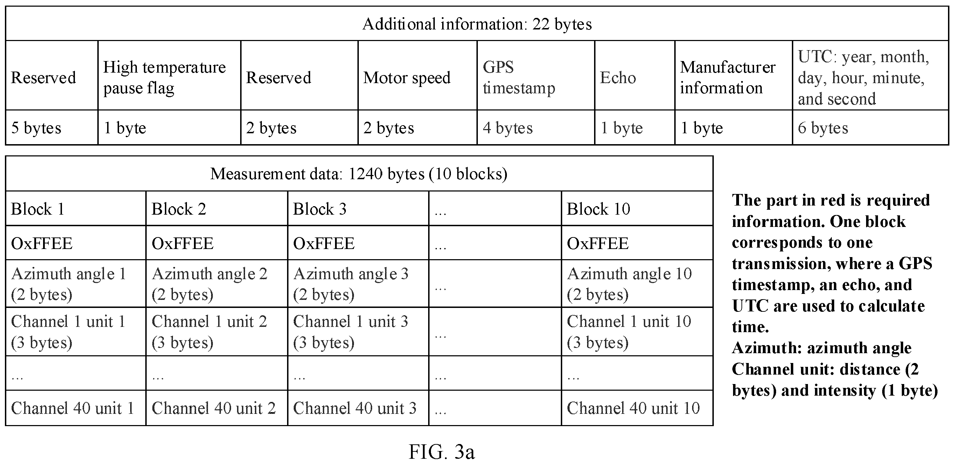

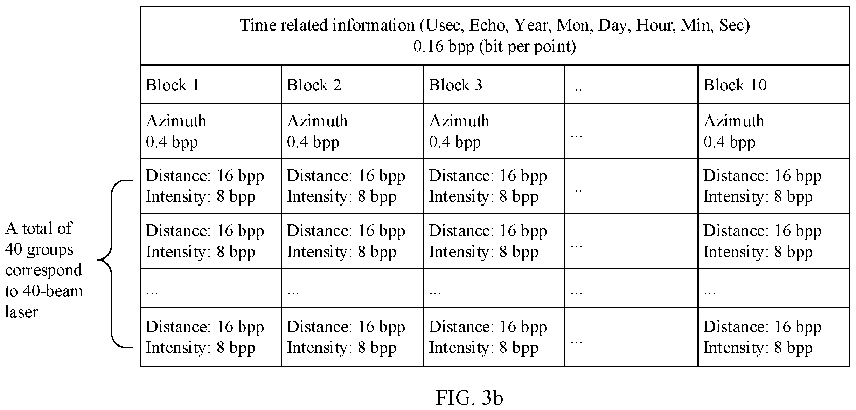

As described above, raw data of the lidar is a user datagram protocol (uUDP) data packet or packet data. FIG. 3a is a schematic of a format of UDP data according to an embodiment of this application. As shown in FIG. 3a, the UDP data includes additional information and measurement data. The additional information includes a global positioning system (GPS) timestamp, an echo, and universal time coordinated (UTC), and is used to obtain time information. The measurement data includes 10 data blocks. One block corresponds to one lidar transmission. One piece of azimuth angle measurement data and 40 (indicating that 40-beam lidar has 40 laser emission modules) pieces of channel unit measurement data may be obtained in each transmission. FIG. 3b is a schematic of a format of packet data according to an embodiment of this application. As shown in FIG. 3b, the UDP data shown in FIG. 3a is sorted to obtain packet data. In the packet data, one block still corresponds to one lidar transmission. One block includes one piece of azimuth angle measurement data and 40 groups of distance measurement data and signal intensity measurement data. It can be learned that the distance measurement data and the signal intensity measurement data are in a one-to-one correspondence.

Based on this, the to-be-compressed data in an embodiment of this application is measurement data collected by lidar through N transmissions, where N ≥ 1. In the foregoing example, N = 10. A quantity of groups of distance measurement data and signal intensity measurement data is associated with a quantity of beams of the lidar. This is not specifically limited in embodiments of this application. In addition, the to-be-compressed data in an embodiment of this application may be the foregoing UDP data, or may be the foregoing packet data. However, for ease of subsequent processing, if the to-be-compressed data is UDP data, the UDP data may be sorted into packet data, and then subsequent steps are performed.

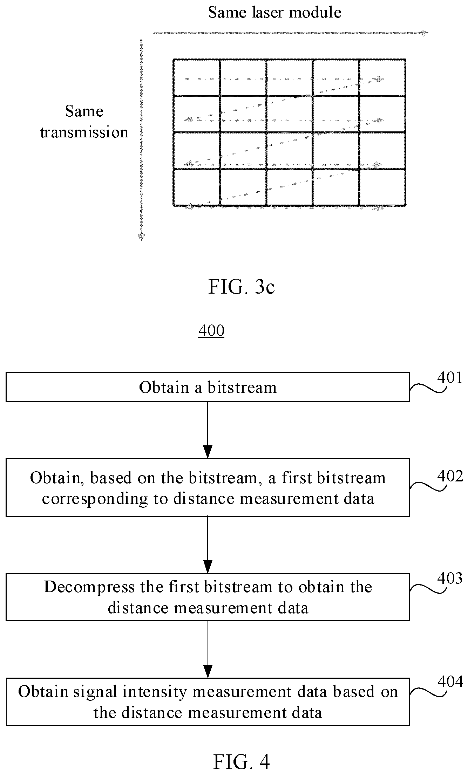

After obtaining the packet data, the encoder may arrange each type of measurement data included in the to-be-compressed data into a two-dimensional matrix. For example, FIG. 3c is a schematic of a two-dimensional matrix according to an embodiment of this application. As shown in FIG. 3c, one row of the matrix corresponds to one laser of lidar, and one column of the matrix corresponds to one transmission of the lidar. According to the above example, the lidar has a total of 40 beams (lasers), and 10 transmissions are required. If the distance measurement data is represented as a matrix, the matrix is a 40 × 10 two-dimensional matrix. Each element in the matrix corresponds to one piece of distance measurement data. When compressing the distance measurement data, the encoder may sequentially extract elements from the matrix in a direction of an arrow shown in FIG. 3c.

It should be noted that an element extraction sequence shown in FIG. 3c is merely an example, and constitutes no limitation on the implementation method. This is not specifically limited in embodiments of this application. In addition, FIG. 3c uses distance measurement data as an example to describe a correspondence between a two-dimensional matrix and measurement data. Signal intensity measurement data in the to-be-compressed data may also be represented as a two-dimensional matrix by using a same method, and elements are respectively extracted from the matrix in a same or different sequence.

Step 202: When the to-be-compressed data includes corresponding distance measurement data and signal intensity measurement data, compress the distance measurement data to obtain a first bitstream.

In an embodiment of this application, different compression methods may be applied to different types of measurement data. For the distance measurement data, a compression method applied to an encoder includes the following steps.

In a possible implementation, when the to-be-compressed data includes a plurality of pieces of 0-value distance measurement data, run-length encoding is performed on the plurality of pieces of 0-value distance measurement data to obtain the first bitstream.

As described above, the to-be-compressed data may include a plurality of pieces of distance measurement data. After the plurality of pieces of distance measurement data are arranged into a two-dimensional matrix, a plurality of consecutive pieces of 0-value distance measurement data may exist in an extraction sequence of matrix elements. In this case, run-length encoding may be performed on the 0-value distance measurement data. For example, if there are 10 consecutive pieces of 0-value distance measurement data, the distance measurement data may be compressed and represented as "0, 10", where 0 indicates that a value of the distance measurement data is 0, and 10 indicates that there are 10 pieces of 0-value distance measurement data. Alternatively, the distance measurement data may be compressed and expressed as "0, (0, 9), 10", where 0 indicates that a value of the distance measurement data is 0, (0, 9) indicates a position of a first 0 value in this group of 0-value distance measurement data, and 10 indicates that there are 10 pieces of 0-value distance measurement data. Alternatively, the distance measurement data may be compressed and expressed as "0, (0, 9), (9, 9)", where 0 indicates that a value of the distance measurement data is 0, (0, 9) indicates that a position of a first 0 value in this group of 0-value distance measurement data, and (9, 9) indicates a position of a last 0 value in this group of 0-value distance measurement data. It can be learned that run-length encoding can greatly reduce an amount of compressed data, and a larger quantity of consecutive pieces of 0-value distance measurement data indicates higher compression efficiency. It should be noted that the plurality of pieces of 0-value distance measurement data may alternatively be compressed in another run-length encoding manner. This is not specifically limited in embodiments of this application.

In a possible implementation, when the to-be-compressed data includes a plurality of pieces of non-0 distance measurement data, residual-based entropy encoding is performed on the plurality of pieces of non-0 distance measurement data to obtain the first bitstream.

When the distance measurement data is non-0, the non-0 distance measurement data may be sequentially extracted in the element extraction sequence shown in FIG. 3c, a residual of two adjacent pieces of non-0 distance measurement data is calculated, and then entropy encoding is performed based on the residual. It should be noted that, in an embodiment of this application, residual-based entropy encoding may be performed on the plurality of pieces of non-0 distance measurement data, and calculation may alternatively be performed in another manner. For example, a residual of a current piece of non-0 distance measurement data is calculated based on the foregoing plurality of pieces of non-0 distance measurement data. This is not specifically limited in embodiments of this application.

Step 203: Predict the signal intensity measurement data based on the distance measurement data to obtain a second bitstream.

There is a correspondence between distance measurement data and signal intensity measurement data in a same group. Correspondingly, values of the distance measurement data and the signal intensity measurement data in the same group have an association. For example, when the distance measurement data is 0, the signal intensity measurement data corresponding to the distance measurement data is usually also 0. When the distance measurement data is 0, it indicates that the signal is too weak to provide valid information. Therefore, the distance measurement data is ignored and marked as 0. Correspondingly, the signal intensity measurement data corresponding to the distance measurement data is also marked as 0. Therefore, cross-modal compression may be performed on the distance measurement data and the signal intensity measurement data, to implement optimal compression efficiency.

In a possible implementation, when the distance measurement data is 0, the signal intensity measurement data corresponding to the distance measurement data is also 0. Therefore, the encoder may not process this type of signal intensity measurement data. To be specific, the encoder skips processing the signal intensity measurement data corresponding to the 0-value distance measurement data, and no position in the bitstream is reserved for the signal intensity measurement data. In this way, when the encoder compresses the to-be-compressed data, the signal intensity measurement data corresponding to the 0-value distance measurement data may be ignored, so that a data amount can be greatly reduced. A larger quantity of 0 values indicates higher compression efficiency. This reduces occupied bitstreams.

In a possible implementation, in addition to the foregoing relationship in which a 0 value corresponds to a 0 value, a calculation relationship may exist between the values of the distance measurement data and the signal intensity measurement data in the same group. For example, y=a×x+b, where y represents signal intensity measurement data, x represents distance measurement data corresponding to y, and a and b may be preset parameters. For another example, y=a₁×x₁+a₂×x₂+b, where y represents signal intensity measurement data, x₁ represents distance measurement data corresponding to y, x₂ represents distance measurement data before x₁, and ai, a₂, and b may be preset parameters. It should be noted that the calculation relationship between the distance measurement data and the signal intensity measurement data in the same group may alternatively be represented in another manner. This is not specifically limited in embodiments of this application.

In this case, reference may also be made to the foregoing method. To be specific, the encoder skips processing the signal intensity measurement data that has the calculation relationship with the distance measurement data, and no position in the bitstream is reserved for the signal intensity measurement data. In this way, when the encoder compresses the to-be-compressed data, the signal intensity measurement data that has the calculation relationship with the distance measurement data may be ignored, so that a data amount can be greatly reduced. A larger quantity of pieces of the signal intensity measurement data that has the calculation relationship with the distance measurement data indicates higher compression efficiency. This reduces occupied bitstreams.

In a possible implementation, when the distance measurement data is non-0, the signal intensity measurement data corresponding to the distance measurement data is predicted based on one or more pieces of non-0 distance measurement data to obtain a residual of the signal intensity measurement data. Then, the second bitstream is obtained based on the residual of the signal intensity measurement data.

Optionally, the signal intensity measurement data may be predicted based on the distance measurement data in the same group. For example, the residual of the distance measurement data and the signal intensity measurement data in the same group is calculated, and the residual is used as the residual of the signal intensity measurement data to perform entropy encoding.

Optionally, the signal intensity measurement data may be predicted based on the distance measurement data in the same group and distance measurement data before the distance measurement data. For example, an intermediate value is calculated based on the foregoing plurality of pieces of distance measurement data, and then a residual of the intermediate value and the signal intensity measurement data is calculated. The residual is used as the residual of the signal intensity measurement data to perform entropy encoding.

It should be noted that, in an embodiment of this application, the residual of the signal intensity measurement data may be obtained by using a plurality of methods. This is not specifically limited.

In a possible implementation, when the to-be-compressed data includes a plurality of pieces of non-0 distance measurement data, residual-based entropy encoding is performed on a plurality of pieces of signal intensity measurement data corresponding to the plurality of pieces of non-0 distance measurement data to obtain the second bitstream.

According to the foregoing theory, when the distance measurement data is 0, the signal intensity measurement data corresponding to the distance measurement data is also 0. On the contrary, when the distance measurement data is non-0, the signal intensity measurement data corresponding to the distance measurement data is also non-0. Therefore, the encoder may compress the non-0 signal intensity measurement data by referring to the compression manner of the non-0 distance measurement data.

To be specific, when the signal intensity measurement data is non-0, the non-0 signal intensity measurement data may be sequentially extracted in the element extraction sequence shown in FIG. 3c, a residual of two adjacent pieces of non-0 signal intensity measurement data is calculated, and then entropy encoding is performed based on the residual. It should be noted that, in an embodiment of this application, residual-based entropy encoding may be performed on the plurality of pieces of non-0 signal intensity measurement data, and calculation may alternatively be performed in another manner. For example, a residual of a current piece of non-0 signal intensity measurement data is calculated based on the foregoing plurality of pieces of non-0 signal intensity measurement data. This is not specifically limited in embodiments of this application.

In a possible implementation, non-0 distance measurement data is obtained, non-0 signal intensity measurement data corresponding to the non-0 distance measurement data is predicted based on one or more pieces of non-0 distance measurement data to obtain a first residual, another piece of non-0 signal intensity measurement data is predicted based on the non-0 signal intensity measurement data to obtain a second residual, and finally the second bitstream is obtained based on the first residual and the second residual.

This embodiment of this application is a combination of the foregoing two manners. To be specific, in a plurality of pieces of non-0 signal intensity measurement data, a residual value (the first residual) of one part of the non-0 signal intensity measurement data may be obtained through prediction based on one or more pieces of non-0 distance measurement data, a residual value (the second residual) of another part of the non-0 signal intensity measurement data may be obtained through prediction based on compressed non-0 signal intensity measurement data that is ranked ahead, and finally entropy encoding is performed on the first residual and the second residual. For example, a residual value of non-0 signal intensity measurement data that is ranked first may be obtained through prediction based on non-0 distance measurement data corresponding to the non-0 signal intensity measurement data. A residual value of non-0 signal intensity measurement data that is not ranked first may be obtained through prediction based on non-0 signal intensity measurement data that is ranked before the non-0 signal intensity measurement data.

It should be noted that the values of the distance measurement data and the signal intensity measurement data in the same group have an association. Therefore, based on the association, in an embodiment of this application, the distance measurement data and the signal intensity measurement data may be compressed in a cross-modal manner by using another method. This is not specifically limited.

In addition, in an embodiment of this application, the encoder may further compress time measurement data and azimuth angle measurement data in the to-be-compressed data.

When the to-be-compressed data further includes the time measurement data, run-length encoding, entropy encoding, or residual-based entropy encoding is performed on the time measurement data to obtain a third bitstream; and/or
when the to-be-compressed data further includes the azimuth angle measurement data, run-length encoding, entropy encoding, or residual-based entropy encoding is performed on the azimuth angle measurement data to obtain a fourth bitstream.

For specific implementations of run-length encoding, entropy encoding, or residual-based entropy encoding, refer to the foregoing encoding manner of the distance measurement data. Details are not described herein again.

In an embodiment of this application, the distance measurement data and the signal intensity measurement data in the same group are compressed in the cross-modal manner based on the association between the distance measurement data and the signal intensity measurement data in the same group, so that an amount of the to-be-compressed data is greatly reduced. In particular, a larger quantity of 0 values indicates higher compression efficiency. This reduces occupied bitstreams.

FIG. 4 is a flowchart of a process 400 of a method for decompressing lidar data according to an embodiment of this application. The process 400 may be performed by the decoder (particularly the decompressor 16) in the coding system 10. The process 400 is described as a series of steps or operations. It should be understood that the process 400 may be performed in various sequences and/or may occur simultaneously, and is not limited to an execution sequence shown in FIG. 4. It is assumed that the coding system 10 is used to decompress a bitstream in the process 400 including the following steps. The process 400 may include the following steps.

Step 401: Obtain a bitstream.

The bitstream includes at least one of the following: a first bitstream, a second bitstream, a third bitstream, and a fourth bitstream. For the solution in an embodiment of this application, distance measurement data and signal intensity measurement data are mainly considered. Therefore, the bitstream needs to include at least the first bitstream.

Step 402: Obtain, based on the bitstream, the first bitstream corresponding to the distance measurement data.

Optionally, the bitstream may carry some syntax elements to indicate meanings of different fields in the bitstream. For example, a start position of the first bitstream is labeled, to prompt the decoder that a bitstream after the start position is the first bitstream corresponding to the distance measurement data. For another example, a syntax element indicates a start position (a byte, a bit, or the like) of the first bitstream.

Optionally, the encoder and the decoder may agree on lengths of different bitstreams in advance, for example, the first bitstream corresponding to the distance measurement data, the second bitstream corresponding to the signal intensity measurement data, a third bitstream corresponding to time measurement data, and a fourth bitstream corresponding to azimuth angle measurement data. The lengths of the four bitstreams are preset to be the same, and a sequence is determined. In this case, the decoder may determine, based on a byte or a bit of a currently parsed bitstream, which bitstream in the foregoing four bitstreams is the currently parsed bitstream.

It should be noted that, in an embodiment of this application, the first bitstream may be obtained by using another method. This is not specifically limited.

Step 403: Decompress the first bitstream to obtain the distance measurement data.

In a possible implementation, run-length decoding is performed on the first bitstream to obtain a plurality of consecutive pieces of 0-value distance measurement data. Corresponding to the encoder, the decoder may perform run-length decoding on a corresponding field in the bitstream according to an indication of the syntax element, to obtain the plurality of consecutive pieces of 0-value distance measurement data.

In a possible implementation, entropy decoding is performed on the first bitstream to obtain distance measurement data other than the plurality of consecutive pieces of 0-value distance measurement data.

Similarly, corresponding to the encoder, the decoder may perform entropy decoding on a corresponding field in the bitstream according to an indication of the syntax element to obtain a residual of distance measurement data, and then obtain the corresponding distance measurement data in a calculation manner opposite to that of the encoder. For example, the foregoing residual and the previously obtained distance measurement data are added to obtain current distance measurement data. For another example, an intermediate value is calculated based on the plurality of pieces of obtained distance measurement data, and the foregoing residual and the intermediate value are added to obtain current distance measurement data.

Step 404: Obtain the signal intensity measurement data based on the distance measurement data.

In a possible implementation, when the distance measurement data is 0, the signal intensity measurement data corresponding to the distance measurement data is set to 0.

Corresponding to the first implementation in step 203, when the distance measurement data is 0, the signal intensity measurement data corresponding to the distance measurement data is also 0. Therefore, the decoder may directly set the signal intensity measurement data corresponding to the decompressed 0-value distance measurement data to 0 instead of decompressing the signal intensity measurement data from the bitstream. This can reduce occupied bitstreams and greatly reduce a data amount. A larger quantity of 0 values indicates higher compression efficiency.

In a possible implementation, when the distance measurement data is non-0, the signal intensity measurement data corresponding to the distance measurement data is obtained through calculation only based on the distance measurement data; or when the distance measurement data is non-0, the signal intensity measurement data corresponding to the distance measurement data is obtained through calculation only based on one or more pieces of non-0 distance measurement data obtained through decoding.

Corresponding to the second implementation in step 203, in addition to the foregoing relationship in which a 0 value corresponds to a 0 value, a calculation relationship may exist between values of distance measurement data and signal intensity measurement data in a same group. Therefore, after obtaining the non-0 distance measurement data, the decoder may obtain, through calculation based on a corresponding calculation relationship, the signal intensity measurement data corresponding to the non-0 distance measurement data. For example, y=a×x+b, where y represents signal intensity measurement data, x represents distance measurement data corresponding to y, and a and b may be preset parameters. For another example, y=a₁×x₁+a₂×x₂+b, where y represents signal intensity measurement data, x₁ represents distance measurement data corresponding to y, x₂ represents distance measurement data before x₁, and ai, a₂, and b may be preset parameters. It should be noted that the calculation relationship between the distance measurement data and the signal intensity measurement data in the same group may alternatively be represented in another manner. This is not specifically limited in embodiments of this application. This can also reduce occupied bitstreams and greatly reduce a data amount.

In a possible implementation, the second bitstream corresponding to the signal intensity measurement data is obtained based on the bitstream, the second bitstream is decompressed to obtain a residual of non-0 signal intensity measurement data, and the non-0 signal intensity measurement data is obtained based on the residual and one or more pieces of non-0 distance measurement data obtained through decoding.

Corresponding to the third implementation in step 203, signal intensity measurement data may be predicted based on distance measurement data in a same group, or signal intensity measurement data may be predicted based on distance measurement data in a same group and distance measurement data before the distance measurement data. Based on this, the decoder may parse the bitstream to obtain a residual of the signal intensity measurement data, and then obtain the signal intensity measurement data through prediction based on the residual and the corresponding distance measurement data.

In a possible implementation, the second bitstream corresponding to the signal intensity measurement data is obtained based on the bitstream, and the second bitstream is decompressed to obtain non-0 signal intensity measurement data. Corresponding to the fourth implementation in step 203, the decoder may decompress the non-0 signal intensity measurement data by referring to the decompression manner of the non-0 distance measurement data.

In a possible implementation, non-0 signal intensity measurement data is obtained through prediction based on one or more pieces of non-0 distance measurement data obtained through decoding, and another piece of non-0 signal intensity measurement data is obtained through prediction based on the non-0 signal intensity measurement data.

Corresponding to the fifth implementation in step 203, this embodiment of this application is a combination of the foregoing two manners. To be specific, in a plurality of pieces of non-0 signal intensity measurement data, a residual value (a first residual) of one part of the non-0 signal intensity measurement data may be obtained through prediction based on one or more pieces of non-0 distance measurement data, and a residual value (a second residual) of another part of the non-0 signal intensity measurement data may be obtained through prediction based on compressed non-0 signal intensity measurement data that is ranked ahead. Therefore, after obtaining the foregoing two residuals, the decoder may obtain the signal intensity measurement data through prediction based on the residual and the corresponding distance measurement data.

In addition, the decoder may further obtain, based on the bitstream, the third bitstream corresponding to the time measurement data, and decompress the third bitstream to obtain the time measurement data; and/or may further obtain, based on the bitstream, the fourth bitstream corresponding to the azimuth angle measurement data, and decompress the fourth bitstream to obtain the azimuth angle measurement data. The processing at the decoder corresponds to that at the encoder. Details are not described herein again.

In an embodiment of this application, the distance measurement data and the signal intensity measurement data in the same group are decompressed in a cross-modal manner based on an association between the distance measurement data and the signal intensity measurement data in the same group. Because bitstreams for partial signal intensity measurement data can be saved in the bitstream, a bitstream length is greatly reduced, and compression efficiency is improved.

In addition, an embodiment of this application further provides a method for compressing/decompressing lidar data. To be specific, an encoder obtains to-be-compressed data, where the to-be-compressed data is measurement data collected by lidar through N transmissions, and N ≥ 1. When the to-be-compressed data includes a plurality of pieces of 0-value distance measurement data, run-length encoding is performed on the plurality of pieces of 0-value distance measurement data to obtain a first bitstream. A decoder obtains a bitstream; obtains, based on the bitstream, the first bitstream corresponding to the distance measurement data; and performs run-length decoding on the first bitstream to obtain the plurality of consecutive pieces of 0-value distance measurement data.

When the to-be-compressed data includes the plurality of 0-value distance measurement data, run-length encoding may be applied instead of entropy encoding. This can greatly reduce a data amount and improve compression efficiency. Correspondingly, the decoder may perform run-length decoding on a part of the bitstream to obtain the distance measurement data based on an indication of a syntax element in the bitstream. This can also improve decompression efficiency.

In this case, any one of run-length encoding, entropy encoding, or residual-based entropy encoding is separately performed on non-0 distance measurement data, signal intensity measurement data, time measurement data, and azimuth angle measurement data. Details are not described herein again.

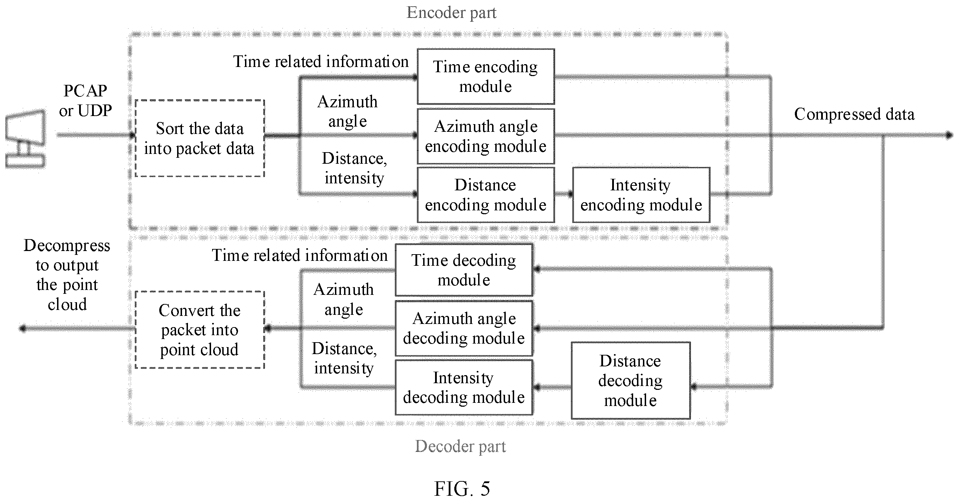

For example, FIG. 5 is a schematic flowchart of a method for compressing/decompressing lidar data according to an embodiment of this application. As shown in FIG. 5, UDP data obtained through measurement by lidar is sorted to obtain packet data. The packet data includes time measurement data, azimuth angle measurement data, distance measurement data, and signal intensity measurement data. A compressor at an encoder may include a plurality of encoding modules. A time encoding module compresses the time measurement data. An azimuth angle encoding module compresses the azimuth angle measurement data. A distance encoding module and a signal intensity encoding module sequentially compress the time measurement data and the signal intensity measurement data. The compressed data is transmitted to a decoder.

A decompressor at the decoder also includes a plurality of decoding modules. A time decoding module decompresses a bitstream corresponding to the time measurement data to obtain the time measurement data. An azimuth angle decoding module decompresses a bitstream corresponding to the azimuth angle measurement data to obtain the azimuth angle measurement data. A distance decoding module and a signal intensity decoding module sequentially decompress a bitstream corresponding to the distance measurement data and a bitstream corresponding to the signal intensity measurement data to obtain the distance measurement data and the signal intensity measurement data. Finally, the packet data reconstructed from the time measurement data, the azimuth angle measurement data, the distance measurement data, and the signal intensity measurement data is converted into point cloud.

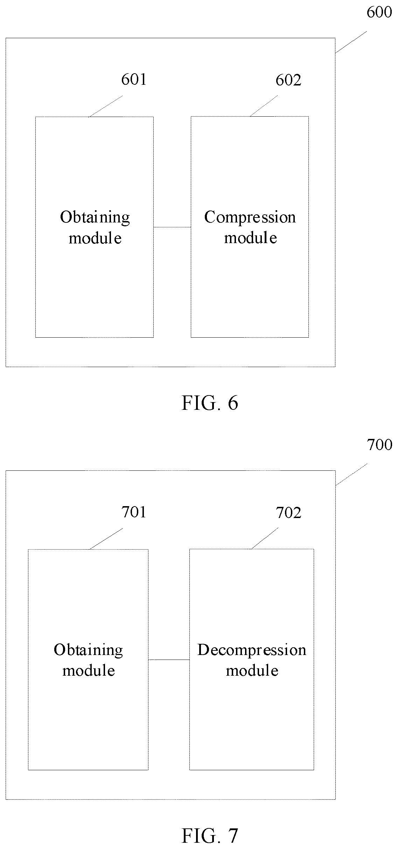

FIG. 6 is an example schematic of a structure of a compression apparatus 600 according to an embodiment of this application. As shown in FIG. 6, the apparatus 600 in an embodiment may be used in a compressor 12. The apparatus 600 may include an obtaining module 601 and a compression module 602.

The obtaining module 601 is configured to obtain to-be-compressed data, where the to-be-compressed data is measurement data collected by lidar through N transmissions, and N ≥ 1. The compression module 602 is configured to: when the to-be-compressed data includes corresponding distance measurement data and signal intensity measurement data, compress the distance measurement data to obtain a first bitstream; and predict the signal intensity measurement data based on the distance measurement data to obtain a second bitstream.

In a possible implementation, the compression module 602 is specifically configured to: when the distance measurement data is non-0, predict, based on one or more pieces of non-0 distance measurement data, the signal intensity measurement data corresponding to the distance measurement data to obtain a residual of the signal intensity measurement data; and obtain the second bitstream based on the residual of the signal intensity measurement data. In a possible implementation, the compression module 602 is specifically configured to: when the to-be-compressed data includes a plurality of pieces of non-0 distance measurement data, perform residual-based entropy encoding on a plurality of pieces of signal intensity measurement data corresponding to the plurality of pieces of non-0 distance measurement data to obtain the second bitstream.

In a possible implementation, the compression module 602 is specifically configured to: obtain non-0 distance measurement data; predict, based on one or more pieces of non-0 distance measurement data, non-0 signal intensity measurement data corresponding to the non-0 distance measurement data to obtain a first residual; predict another piece of non-0 signal intensity measurement data based on the non-0 signal intensity measurement data to obtain a second residual; and obtain the second bitstream based on the first residual and the second residual.

In a possible implementation, the compression module 602 is specifically configured to: when the to-be-compressed data includes a plurality of pieces of 0-value distance measurement data, perform run-length encoding on the plurality of pieces of 0-value distance measurement data to obtain the first bitstream; or when the to-be-compressed data includes a plurality of pieces of non-0 distance measurement data, perform residual-based entropy encoding on the plurality of pieces of non-0 distance measurement data to obtain the first bitstream.

In a possible implementation, the compression module 602 is further configured to: when the to-be-compressed data further includes time measurement data, perform run-length encoding, entropy encoding, or residual-based entropy encoding on the time measurement data to obtain a third bitstream; and/or when the to-be-compressed data further includes azimuth angle measurement data, perform run-length encoding, entropy encoding, or residual-based entropy encoding on the azimuth angle measurement data to obtain a fourth bitstream.

In a possible implementation, the obtaining module 601 is configured to obtain to-be-compressed data, where the to-be-compressed data is measurement data collected by lidar through N transmissions, and N ≥ 1. The compression module 602 is configured to: when the to-be-compressed data includes a plurality of pieces of 0-value distance measurement data, perform run-length encoding on the plurality of pieces of 0-value distance measurement data to obtain a first bitstream.

In a possible implementation, the compression module 602 is further configured to: when the to-be-compressed data includes a plurality of pieces of non-0 distance measurement data, perform residual-based entropy encoding on the plurality of pieces of non-0 distance measurement data to obtain the first bitstream.

In a possible implementation, the compression module 602 is further configured to: when the to-be-compressed data further includes signal intensity measurement data, perform run-length encoding, entropy encoding, or residual-based entropy encoding on the signal intensity measurement data to obtain a second bitstream; when the to-be-compressed data further includes time measurement data, perform run-length encoding, entropy encoding, or residual-based entropy encoding on the time measurement data to obtain a third bitstream; and/or when the to-be-compressed data further includes azimuth angle measurement data, perform run-length encoding, entropy encoding, or residual-based entropy encoding on the azimuth angle measurement data to obtain a fourth bitstream.

FIG. 7 is an example schematic of a structure of a decompression apparatus 700 according to an embodiment of this application. As shown in FIG. 7, the apparatus 700 in an embodiment may be used in a decompressor 16. The apparatus 700 may include an obtaining module 701 and a decompression module 702.

The obtaining module 701 is configured to: obtain a bitstream; and obtain, based on the bitstream, a first bitstream corresponding to distance measurement data. The decompression module 702 is configured to: decompress the first bitstream to obtain the distance measurement data; and obtain signal intensity measurement data based on the distance measurement data.

In a possible implementation, the decompression module 702 is specifically configured to: when the distance measurement data is 0, set the signal intensity measurement data corresponding to the distance measurement data to 0.

In a possible implementation, the decompression module 702 is specifically configured to: when the distance measurement data is non-0, obtain, through calculation only based on the distance measurement data, the signal intensity measurement data corresponding to the distance measurement data; or when the distance measurement data is non-0, obtain, through calculation only based on one or more pieces of non-0 distance measurement data obtained through decoding, the signal intensity measurement data corresponding to the distance measurement data.

In a possible implementation, the decompression module 702 is specifically configured to: obtain, based on the bitstream, a second bitstream corresponding to the signal intensity measurement data; decompress the second bitstream to obtain a residual of non-0 signal intensity measurement data; and obtain the non-0 signal intensity measurement data based on the residual and one or more pieces of non-0 distance measurement data obtained through decoding.

In a possible implementation, the obtaining module 701 is further configured to obtain, based on the bitstream, a second bitstream corresponding to the signal intensity measurement data; and the decompression module 702 is further configured to decompress the second bitstream to obtain non-0 signal intensity measurement data.

In a possible implementation, the decompression module 702 is specifically configured to: obtain non-0 signal intensity measurement data through prediction based on one or more pieces of non-0 distance measurement data obtained through decoding; and obtain another piece of non-0 signal intensity measurement data through prediction based on the non-0 signal intensity measurement data.

In a possible implementation, the decompression module 702 is specifically configured to perform run-length decoding on the first bitstream to obtain a plurality of consecutive pieces of 0-value distance measurement data.

In a possible implementation, the decompression module 702 is specifically configured to perform entropy decoding on the first bitstream to obtain distance measurement data other than the plurality of consecutive pieces of 0-value distance measurement data.

In a possible implementation, the obtaining module 701 is further configured to obtain, based on the bitstream, a third bitstream corresponding to time measurement data; and the decompression module 702 is further configured to decompress the third bitstream to obtain the time measurement data.

In a possible implementation, the obtaining module 701 is further configured to obtain, based on the bitstream, a fourth bitstream corresponding to azimuth angle measurement data; and the decompression module 702 is further configured to decompress the fourth bitstream to obtain the azimuth angle measurement data.

In a possible implementation, the decompressing includes run-length decoding, entropy decoding, or residual-based entropy decoding.

In a possible implementation, the obtaining module 701 is configured to: obtain a bitstream; and obtain, based on the bitstream, a first bitstream corresponding to distance measurement data; and the decompression module 702 is configured to perform run-length decoding on the first bitstream to obtain a plurality of consecutive pieces of 0-value distance measurement data.

In a possible implementation, the decompression module 702 is further configured to perform entropy decoding on the first bitstream to obtain distance measurement data other than the plurality of consecutive pieces of 0-value distance measurement data.

In a possible implementation, the obtaining module 701 is further configured to obtain, based on the bitstream, a second bitstream corresponding to signal intensity measurement data; and the decompression module 702 is further configured to decompress the second bitstream to obtain the signal intensity measurement data.

In a possible implementation, the obtaining module 701 is further configured to obtain, based on the bitstream, a third bitstream corresponding to time measurement data; and the decompression module 702 is further configured to decompress the third bitstream to obtain the time measurement data.

In a possible implementation, the obtaining module 701 is further configured to obtain, based on the bitstream, a fourth bitstream corresponding to azimuth angle measurement data; and the decompression module 702 is further configured to decompress the fourth bitstream to obtain the azimuth angle measurement data.

In a possible implementation, the decompressing includes run-length decoding, entropy decoding, or residual-based entropy decoding.

In an implementation process, steps in the foregoing method embodiments can be implemented by using a hardware integrated logical circuit in the processor, or by using instructions in a form of software. The processor may be a general-purpose processor, a digital signal processor (DSP), an application-specific integrated circuit (ASIC), a field programmable gate array (FPGA) or another programmable logic device, a discrete gate or transistor logic device, or a discrete hardware component. The general-purpose processor may be a microprocessor, or the processor may be any conventional processor or the like. The steps of the methods disclosed in embodiments of this application may be directly presented as being performed and completed by a hardware encoding processor, or performed and completed by a combination of hardware and a software module in an encoding processor. The software module may be located in a mature storage medium in the art, for example, a random access memory, a flash memory, a read-only memory, a programmable read-only memory, an electrically erasable programmable memory, or a register. The storage medium is located in the memory, and the processor reads information in the memory and completes the steps in the foregoing methods in combination with hardware of the processor.

The memory in the foregoing embodiments may be a volatile memory or a non-volatile memory, or may include both a volatile memory and a non-volatile memory. The nonvolatile memory may be a read-only memory (ROM), a programmable read-only memory (PROM), an erasable programmable read-only memory (erasable PROM, EPROM), an electrically erasable programmable read-only memory (electrically EPROM, EEPROM), or a flash memory. The volatile memory may be a random access memory (RAM) and is used as an external cache. By way of example and not limitation, RAMs in many forms may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM). It should be noted that the memory in the systems and methods described in this specification includes but is not limited to these and any memory of another appropriate type.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In several embodiments provided in this application, it should be understood that the disclosed system, apparatus, and method may be implemented in another manner. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or another form.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments. In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions in this application essentially, or the part contributing to the conventional technology, or a part of the technical solutions may be implemented in a form of a software product. The computer software product is stored in a storage medium and includes several instructions for instructing a computer device (a personal computer, a server, a network device, or the like) to perform all or a part of the steps of the methods in embodiments of this application. The foregoing storage medium includes any medium that can store program code, such as a USB flash drive, a removable hard disk, a read-only memory (ROM), a random access memory (RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A method for compressing lidar data, comprising:
obtaining a bitstream;
obtaining, based on the bitstream, a first bitstream corresponding to distance measurement data;
decompressing the first bitstream to obtain the distance measurement data; and
obtaining signal intensity measurement data based on the distance measurement data.

2. The method according to claim 1, wherein the obtaining signal intensity measurement data based on the distance measurement data comprises:
when the distance measurement data is 0, setting the signal intensity measurement data corresponding to the distance measurement data to 0.

3. The method according to claim 1 or 2, wherein the obtaining signal intensity measurement data based on the distance measurement data comprises:
when the distance measurement data is non-0, obtaining, through calculation only based on the distance measurement data, the signal intensity measurement data corresponding to the distance measurement data; or
when the distance measurement data is non-0, obtaining, through calculation only based on one or more pieces of non-0 distance measurement data obtained through decoding, the signal intensity measurement data corresponding to the distance measurement data.

4. The method according to claim 1 or 2, wherein the obtaining signal intensity measurement data based on the distance measurement data comprises:
obtaining, based on the bitstream, a second bitstream corresponding to the signal intensity measurement data;
decompressing the second bitstream to obtain a residual of non-0 signal intensity measurement data; and
obtaining the non-0 signal intensity measurement data based on the residual and one or more pieces of non-0 distance measurement data obtained through decoding.

5. The method according to claim 2, wherein the method further comprises:
obtaining, based on the bitstream, a second bitstream corresponding to the signal intensity measurement data; and
decompressing the second bitstream to obtain non-0 signal intensity measurement data.

6. The method according to claim 1 or 2, wherein the obtaining signal intensity measurement data based on the distance measurement data comprises:
obtaining non-0 signal intensity measurement data through prediction based on one or more pieces of non-0 distance measurement data obtained through decoding; and
obtaining another piece of non-0 signal intensity measurement data through prediction based on the non-0 signal intensity measurement data.

7. The method according to any one of claims 1 to 6, wherein the decompressing the first bitstream to obtain the distance measurement data comprises:
performing run-length decoding on the first bitstream to obtain a plurality of consecutive pieces of 0-value distance measurement data.

8. The method according to claim 7, wherein the decompressing the first bitstream to obtain the distance measurement data comprises:
performing entropy decoding on the first bitstream to obtain distance measurement data other than the plurality of consecutive pieces of 0-value distance measurement data.

9. The method according to any one of claims 1 to 8, wherein the method further comprises:
obtaining, based on the bitstream, a third bitstream corresponding to time measurement data; and
decompressing the third bitstream to obtain the time measurement data.

10. The method according to any one of claims 1 to 9, wherein the method further comprises:
obtaining, based on the bitstream, a fourth bitstream corresponding to azimuth angle measurement data; and
decompressing the fourth bitstream to obtain the azimuth angle measurement data.

11. The method according to any one of claims 1 to 10, wherein the decompressing comprises run-length decoding, entropy decoding, or residual-based entropy decoding.

12. A method for compressing lidar data, comprising:
obtaining to-be-compressed data, wherein the to-be-compressed data is measurement data collected by lidar through N transmissions, and N ≥ 1;
when the to-be-compressed data comprises corresponding distance measurement data and signal intensity measurement data, compressing the distance measurement data to obtain a first bitstream; and
predicting the signal intensity measurement data based on the distance measurement data to obtain a second bitstream.

13. The method according to claim 12, wherein the predicting the signal intensity measurement data based on the distance measurement data to obtain a second bitstream comprises:
when the distance measurement data is non-0, predicting, based on one or more pieces of non-0 distance measurement data, the signal intensity measurement data corresponding to the distance measurement data to obtain a residual of the signal intensity measurement data; and
obtaining the second bitstream based on the residual of the signal intensity measurement data.

14. The method according to claim 12, wherein the predicting the signal intensity measurement data based on the distance measurement data to obtain a second bitstream comprises:
when the to-be-compressed data comprises a plurality of pieces of non-0 distance measurement data, performing residual-based entropy encoding on a plurality of pieces of signal intensity measurement data corresponding to the plurality of pieces of non-0 distance measurement data to obtain the second bitstream.

15. The method according to claim 12, wherein the predicting the signal intensity measurement data based on the distance measurement data to obtain a second bitstream comprises:
obtaining non-0 distance measurement data;
predicting, based on one or more pieces of non-0 distance measurement data, non-0 signal intensity measurement data corresponding to the non-0 distance measurement data to obtain a first residual;
predicting another piece of non-0 signal intensity measurement data based on the non-0 signal intensity measurement data to obtain a second residual; and
obtaining the second bitstream based on the first residual and the second residual.

16. The method according to any one of claims 12 to 15, wherein the compressing the distance measurement data to obtain a first bitstream comprises:
when the to-be-compressed data comprises a plurality of pieces of 0-value distance measurement data, performing run-length encoding on the plurality of pieces of 0-value distance measurement data to obtain the first bitstream; or
when the to-be-compressed data comprises a plurality of pieces of non-0 distance measurement data, performing residual-based entropy encoding on the plurality of pieces of non-0 distance measurement data to obtain the first bitstream.

17. The method according to any one of claims 12 to 16, wherein the method further comprises:
when the to-be-compressed data further comprises time measurement data, performing run-length encoding, entropy encoding, or residual-based entropy encoding on the time measurement data to obtain a third bitstream; and/or
when the to-be-compressed data further comprises azimuth angle measurement data, performing run-length encoding, entropy encoding, or residual-based entropy encoding on the azimuth angle measurement data to obtain a fourth bitstream.

18. A method for compressing lidar data, comprising:
obtaining to-be-compressed data, wherein the to-be-compressed data is measurement data collected by lidar through N transmissions, and N ≥ 1; and
when the to-be-compressed data comprises a plurality of pieces of 0-value distance measurement data, performing run-length encoding on the plurality of pieces of 0-value distance measurement data to obtain a first bitstream.

19. The method according to claim 18, wherein the method further comprises:
when the to-be-compressed data comprises a plurality of pieces of non-0 distance measurement data, performing residual-based entropy encoding on the plurality of pieces of non-0 distance measurement data to obtain the first bitstream.

20. The method according to claim 18 or 19, wherein the method further comprises:
when the to-be-compressed data further comprises signal intensity measurement data, performing run-length encoding, entropy encoding, or residual-based entropy encoding on the signal intensity measurement data to obtain a second bitstream;
when the to-be-compressed data further comprises time measurement data, performing run-length encoding, entropy encoding, or residual-based entropy encoding on the time measurement data to obtain a third bitstream; and/or
when the to-be-compressed data further comprises azimuth angle measurement data, performing run-length encoding, entropy encoding, or residual-based entropy encoding on the azimuth angle measurement data to obtain a fourth bitstream.

21. A method for decompressing lidar data, comprising:
obtaining a bitstream;
obtaining, based on the bitstream, a first bitstream corresponding to distance measurement data;
performing run-length decoding on the first bitstream to obtain a plurality of consecutive pieces of 0-value distance measurement data.

22. The method according to claim 21, wherein the method further comprises:
performing entropy decoding on the first bitstream to obtain distance measurement data other than the plurality of consecutive pieces of 0-value distance measurement data.

23. The method according to claim 21 or 22, wherein the method further comprises:
obtaining, based on the bitstream, a second bitstream corresponding to signal intensity measurement data; and
decompressing the second bitstream to obtain the signal intensity measurement data.

24. The method according to any one of claims 21 to 23, wherein the method further comprises:
obtaining, based on the bitstream, a third bitstream corresponding to time measurement data; and
decompressing the third bitstream to obtain the time measurement data.

25. The method according to any one of claims 21 to 24, wherein the method further comprises:
obtaining, based on the bitstream, a fourth bitstream corresponding to azimuth angle measurement data; and
decompressing the fourth bitstream to obtain the azimuth angle measurement data.

26. The method according to any one of claims 23 to 25, wherein the decompressing comprises run-length decoding, entropy decoding, or residual-based entropy decoding.

27. A decompression apparatus, comprising:
an obtaining module, configured to: obtain a bitstream; and obtain, based on the bitstream, a first bitstream corresponding to distance measurement data; and
a decompression module, configured to: decompress the first bitstream to obtain the distance measurement data; and obtain signal intensity measurement data based on the distance measurement data.

28. The apparatus according to claim 27, wherein the decompression module is specifically configured to: when the distance measurement data is 0, set the signal intensity measurement data corresponding to the distance measurement data to 0.

29. The apparatus according to claim 27 or 28, wherein the decompression module is specifically configured to: when the distance measurement data is non-0, obtain, through calculation only based on the distance measurement data, the signal intensity measurement data corresponding to the distance measurement data; or when the distance measurement data is non-0, obtain, through calculation only based on one or more pieces of non-0 distance measurement data obtained through decoding, the signal intensity measurement data corresponding to the distance measurement data.

30. The apparatus according to claim 27 or 28, wherein the decompression module is specifically configured to: obtain, based on the bitstream, a second bitstream corresponding to the signal intensity measurement data; decompress the second bitstream to obtain a residual of non-0 signal intensity measurement data; and obtain the non-0 signal intensity measurement data based on the residual and one or more pieces of non-0 distance measurement data obtained through decoding.

31. The apparatus according to claim 28, wherein the obtaining module is further configured to obtain, based on the bitstream, a second bitstream corresponding to the signal intensity measurement data; and
the decompression module is further configured to decompress the second bitstream to obtain non-0 signal intensity measurement data.

32. The apparatus according to claim 27 or 28, wherein the decompression module is specifically configured to: obtain non-0 signal intensity measurement data through prediction based on one or more pieces of non-0 distance measurement data obtained through decoding; and obtain another piece of non-0 signal intensity measurement data through prediction based on the non-0 signal intensity measurement data.

33. The apparatus according to any one of claims 27 to 32, wherein the decompression module is specifically configured to perform run-length decoding on the first bitstream to obtain a plurality of consecutive pieces of 0-value distance measurement data.

34. The apparatus according to claim 33, wherein the decompression module is specifically configured to perform entropy decoding on the first bitstream to obtain distance measurement data other than the plurality of consecutive pieces of 0-value distance measurement data.

35. The apparatus according to any one of claims 27 to 34, wherein the obtaining module is further configured to obtain, based on the bitstream, a third bitstream corresponding to time measurement data; and
the decompression module is further configured to decompress the third bitstream to obtain the time measurement data.

36. The apparatus according to any one of claims 27 to 35, wherein the obtaining module is further configured to obtain, based on the bitstream, a fourth bitstream corresponding to azimuth angle measurement data; and
the decompression module is further configured to decompress the fourth bitstream to obtain the azimuth angle measurement data.

37. The apparatus according to any one of claims 27 to 36, wherein the decompressing comprises run-length decoding, entropy decoding, or residual-based entropy decoding.

38. A compression apparatus, comprising:
an obtaining module, configured to obtain to-be-compressed data, wherein the to-be-compressed data is measurement data collected by lidar through N transmissions, and N ≥ 1; and
a compression module, configured to: when the to-be-compressed data comprises corresponding distance measurement data and signal intensity measurement data, compress the distance measurement data to obtain a first bitstream; and predict the signal intensity measurement data based on the distance measurement data to obtain a second bitstream.

39. The apparatus according to claim 38, wherein the compression module is specifically configured to: when the distance measurement data is non-0, predict, based on one or more pieces of non-0 distance measurement data, the signal intensity measurement data corresponding to the distance measurement data to obtain a residual of the signal intensity measurement data; and obtain the second bitstream based on the residual of the signal intensity measurement data.

40. The apparatus according to claim 38, wherein the compression module is specifically configured to: when the to-be-compressed data comprises a plurality of pieces of non-0 distance measurement data, perform residual-based entropy encoding on a plurality of pieces of signal intensity measurement data corresponding to the plurality of pieces of non-0 distance measurement data to obtain the second bitstream.

41. The apparatus according to claim 38, wherein the compression module is specifically configured to: obtain non-0 distance measurement data; predict, based on one or more pieces of non-0 distance measurement data, non-0 signal intensity measurement data corresponding to the non-0 distance measurement data to obtain a first residual; predict another piece of non-0 signal intensity measurement data based on the non-0 signal intensity measurement data to obtain a second residual; and obtain the second bitstream based on the first residual and the second residual.

42. The apparatus according to any one of claims 38 to 41, wherein the compression module is specifically configured to: when the to-be-compressed data comprises a plurality of pieces of 0-value distance measurement data, perform run-length encoding on the plurality of pieces of 0-value distance measurement data to obtain the first bitstream; or when the to-be-compressed data comprises a plurality of pieces of non-0 distance measurement data, perform residual-based entropy encoding on the plurality of pieces of non-0 distance measurement data to obtain the first bitstream.

43. The apparatus according to any one of claims 38 to 42, wherein the compression module is further configured to: when the to-be-compressed data further comprises time measurement data, perform run-length encoding, entropy encoding, or residual-based entropy encoding on the time measurement data to obtain a third bitstream; and/or when the to-be-compressed data further comprises azimuth angle measurement data, perform run-length encoding, entropy encoding, or residual-based entropy encoding on the azimuth angle measurement data to obtain a fourth bitstream.

44. A compression apparatus, comprising:
an obtaining module, configured to obtain to-be-compressed data, wherein the to-be-compressed data is measurement data collected by lidar through N transmissions, and N ≥ 1; and
a compression module, configured to: when the to-be-compressed data comprises a plurality of pieces of 0-value distance measurement data, perform run-length encoding on the plurality of pieces of 0-value distance measurement data to obtain a first bitstream.

45. The apparatus according to claim 44, wherein the compression module is further configured to: when the to-be-compressed data comprises a plurality of pieces of non-0 distance measurement data, perform residual-based entropy encoding on the plurality of pieces of non-0 distance measurement data to obtain the first bitstream.

46. The apparatus according to claim 44 or 45, wherein the compression module is further configured to: when the to-be-compressed data further comprises signal intensity measurement data, perform run-length encoding, entropy encoding, or residual-based entropy encoding on the signal intensity measurement data to obtain a second bitstream; when the to-be-compressed data further comprises time measurement data, perform run-length encoding, entropy encoding, or residual-based entropy encoding on the time measurement data to obtain a third bitstream; and/or when the to-be-compressed data further comprises azimuth angle measurement data, perform run-length encoding, entropy encoding, or residual-based entropy encoding on the azimuth angle measurement data to obtain a fourth bitstream.

47. A decompression apparatus, comprising:
an obtaining module, configured to: obtain a bitstream; and obtain, based on the bitstream, a first bitstream corresponding to distance measurement data; and
a decompression module, configured to perform run-length decoding on the first bitstream to obtain a plurality of consecutive pieces of 0-value distance measurement data.

48. The apparatus according to claim 47, wherein the decompression module is further configured to perform entropy decoding on the first bitstream to obtain distance measurement data other than the plurality of consecutive pieces of 0-value distance measurement data.

49. The apparatus according to claim 47 or 48, wherein the obtaining module is further configured to obtain, based on the bitstream, a second bitstream corresponding to signal intensity measurement data; and
the decompression module is further configured to decompress the second bitstream to obtain the signal intensity measurement data.

50. The apparatus according to any one of claims 47 to 49, wherein the obtaining module is further configured to obtain, based on the bitstream, a third bitstream corresponding to time measurement data; and
the decompression module is further configured to decompress the third bitstream to obtain the time measurement data.

51. The apparatus according to any one of claims 47 to 50, wherein the obtaining module is further configured to obtain, based on the bitstream, a fourth bitstream corresponding to azimuth angle measurement data; and
the decompression module is further configured to decompress the fourth bitstream to obtain the azimuth angle measurement data.

52. The apparatus according to any one of claims 48 to 51, wherein the decompressing comprises run-length decoding, entropy decoding, or residual-based entropy decoding.

53. An electronic device, comprising:
one or more processors; and
a memory, configured to store one or more programs, wherein
when the one or more programs are executed by the one or more processors, the one or more processors are enabled to implement the method according to any one of claims 1 to 26.

54. A computer-readable storage medium, comprising a computer program, wherein when the computer program is executed on a computer, the computer is enabled to perform the method according to any one of claims 1 to 26.

55. A computer program product, wherein the computer program product comprises computer program code, and when the computer program code is run on a computer, the method according to any one of claims 1 to 26 is performed.
